# EUROPEAN PATENT APPLICATION

(11) **EP 2 001 007 A2**
(43) Date of publication of application: **10.12.2008**
(21) Application number: 07738269.5
(22) Date of filing: 12.03.2007
(51) Int. Cl.: G09F 9/00, H05K 9/00

(54) **ELECTRICALLY CONDUCTIVE APPARATUS AND ELECTRONIC DEVICE**

(30) Priority: 30.03.2006 JP 2006093607
(71) Applicant: Pioneer Corporation, Tokyo 153-8654 (JP)
(72) Inventor: MIYAMURA, Yukiharu, Ota-ku, Tokyo 1438564 (JP)
(74) Representative: Haley, Stephen
(86) International application number: PCT/JP2007/054797
(87) International publication number: WO 2007/113993

(57) **Abstract**

A gasket (200) includes a body (210), a projection (220) and a conductive fiber member (230). The body (200) includes: a PDP-side face (211) facing an electrode face (111) of a PDP (110); and a chassis-side face (212) facing a grounding electrode face (131) of a chassis (130). The projection (220) is raised from a first end of the body (210) upward to an inner surface of a front case (120). The conductive fiber member (230) is continuously formed to cover the PDP-side face (211), a connecting face (213) and the chassis-side face (212) of the body (210).

## Description

### Technical Field

The present invention relates to an electric conductor for conducting electricity and an electronic device. The invention particularly relates to an electric conductor for grounding electromagnetic waves of a PDP.

### Background Art

Arrangements for grounding connectors for connecting signal wires to electronic components such as PDP (plasma display panel) have been known (for instance, see Patent Document 1).

The Patent Document 1 discloses a PDP display unit arranged such that a ground layer of a PDP and a shield case are connected by a shield gasket in order to prevent a leak of electromagnetic waves of the PDP. According to this arrangement of the PDP display unit, a conductive screen filter is provided to face the PDP and supported by a case.

However, such an arrangement as disclosed in the Patent Document 1 increases a thickness dimension because the filter is provided therein, and manufacturing thereof may be complicated. In view of such a problem, an arrangement in which a filter is removed and a surface of the PDP is directly exposed through an opening of the case has been known. In such an arrangement, in order to prevent a contact of the case with the PDP, a cushion rubber is known to be disposed between the case and the PDP.

[Patent Document 1] JP-A-11-219122 (see pages 4 and 5, and Fig. 2)

### Disclosure of the Invention

### Problems to Be Solved by the Invention

In the above-described arrangement in which a cushion rubber is disposed between the case and the PDP, a clearance of a predetermined space is required to be provided between the cushion rubber and the shield gasket. Specifically, in order to secure a molding balance between the case and the shield case and an allowance space for assembling, the cushion rubber is required to be disposed in a manner spaced apart from the shield gasket by a predetermined dimension. Accordingly, a display area of the PDP is reduced by the dimension of the clearance. In addition, the above arrangement requires the cushion rubber to be disposed between the PDP and the case while requiring the shield gasket to be disposed between the PDP and the shield case, which increases the number of components for the unit and complicates an arrangement of the unit. Manufacturability of the unit is also deteriorated.

In view of such problems as exemplified above, an object of the invention is to provide an electric conductor for suitably conducting electricity with a simplified arrangement and an electronic device including the electric conductor.

### Means for Solving the Problems

An electric conductor according to an aspect of the invention is an electric conductor for electrically connecting an electronic-component connecting member with a conductive member, the electronic-component connecting member being electrically connected to an electronic component disposed within a case, the electronic-component connecting member having a first opposing face that faces one surface of the case, the conductive member being provided between the case and the electronic-component connecting member, the conductive member having a second opposing face that faces the first opposing face of the electronic-component connecting member, the electric conductor including: a substantially plate-shaped body formed from an elastic material, the body having paired faces that substantially face the first opposing face of the electronic-component connecting member and the second opposing face of the conductive member respectively; a projection formed from an elastic material integrally with the body, the projection projecting from a first end of the body toward the one surface of the case, a projecting end of the projection adapted to abut on the one surface of the case; conductive flexible portions made from a conductive and flexible material, the conductive flexible portions being respectively provided on the paired faces of the body; and a connecting portion that electrically connects the conductive flexible portions provided on the paired faces with each other.

An electronic device according to another aspect of the invention includes; a case; an electronic component disposed within the case; an electronic-component connecting member electrically connected to the electronic component, the electronic-component connecting member having a first opposing face that faces one surface of the case; a conductive member provided between the case and the electronic-component connecting member, the conductive member having a second opposing face that faces the first opposing face; and the above-described electric conductor, the electric conductor electrically connecting the conductive member with the electronic-component connecting member.

### Brief Description of Drawings

Fig. 1 is a cross-sectional view schematically showing an arrangement of a primary portion of a PDP according to an exemplary embodiment of the present invention.
Fig. 2 is a perspective view schematically showing an arrangement of a gasket.

### Explanation of Codes

100···PDP display unit as electronic device
110···PDP as electronic component and display
111···PDP electrode as electronic-component connecting member
113···electrode face as first opposing face
120···front case as case
121···opening
124···inner surface as one surface of case
130···chassis as conductive member
131···grounding electrode face as second opposing face
200···gasket as electric conductor
210···body
220···projection
221 ···projecting end
222···decorative surface
230···conductive fiber member included in conductive flexible portion and connecting portion

### Best Mode for Carrying Out the Invention

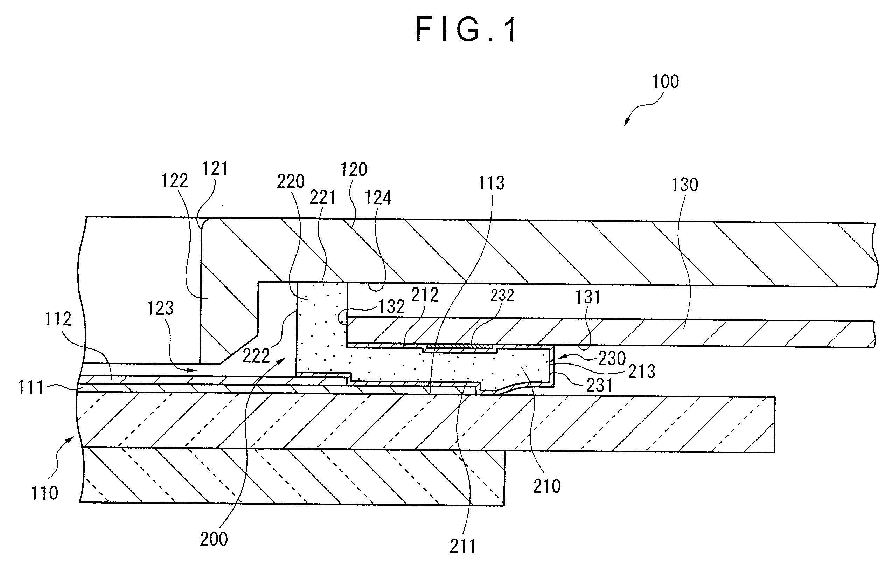

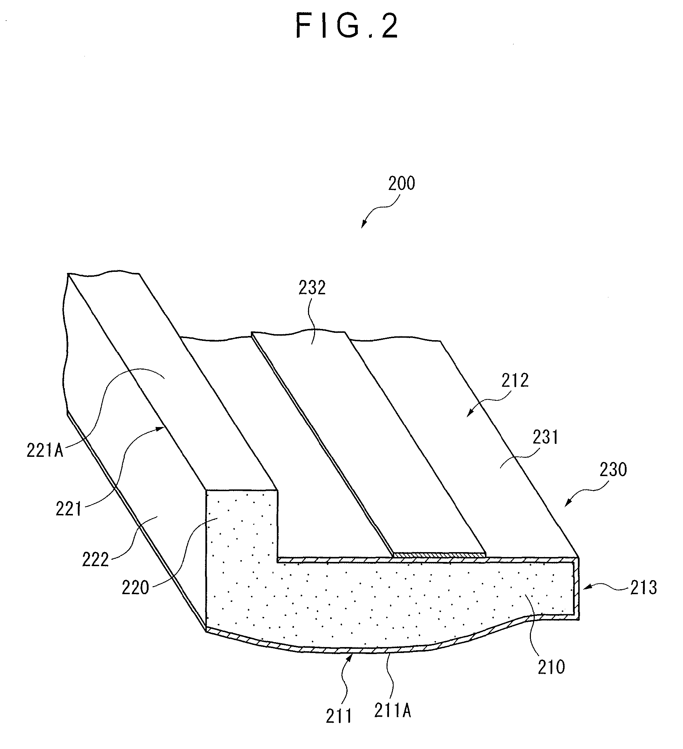

An exemplary embodiment of the present invention will be described below with reference to the attached drawings. It should be noted that, while an electronic device is exemplarily a plasma display panel (hereinafter abbreviated as PDP) in the description of this embodiment, the electronic device may be any other electronic device. Fig. 1 is a cross-sectional view schematically showing an arrangement of a primary portion of a PDP according to an exemplary embodiment of the present invention. Fig. 2 is a perspective view schematically showing an arrangement of a gasket.

### Arrangement of Plasma Display Panel

In Fig. 1, a numeral 100 denotes a PDP display unit as an electronic device. The PDP display unit 100, for instance, displays an image on a PDP (plasma display panel) 110 using luminescence generated by plasma discharge, and outputs audio from an audio output portion (not shown). The PDP 110, which is substantially rectangular in planar view, serves as an electronic component and a display. The PDP display unit 100 includes a front case 120.

The front case 120, which is substantially shaped as a thin box, is exemplarily made from a non-conductive material. One surface of the front case 120 is provided with an opening 121, and a display area of the PDP is provided to face the opening 121. The opening 121 is further provided with a flange 122 along an edge of the opening. The flange 122 projects inward of the front case 120, i.e., projects toward the PDP 110. A clearance 123 of a predetermined dimension is provided between a projecting end of the flange 122 and the PDP 110, thereby preventing a contact of the flange 122 with the PDP 110. In the front case 120, a chassis 130 (a conductive member), a gasket 200 (an electric conductor), the PDP 110 (an electronic component), a processor (not shown), the audio outputting section (not shown), a tuner (not shown) and the like are provided.

The processor is exemplarily provided on a circuit board (not shown) that is electrically connected with the audio outputting section, the tuner, the PDP 110 and the like. The processor obtains a signal from the tuner and displays an image based on the signal on the PDP 110. The processor also controls the audio outputting section to output audio based on the signal from the tuner. The audio outputting section, which is exposed at a lower front surface of the front case 120, is controlled by the processor to output audio. The tuner, which is connected to, for instance, an antenna (not shown), converts a signal received by the antenna into a predetermined signal and outputs the converted signal to the processor.

The PDP 110, which faces the opening 121 of the front case 120 as described above, closes the opening 121. The PDP 110 is provided with a PDP electrode 111 (electronic-component connecting member) at a front surface thereof. Further, a display area, which is exposed to the outside through the opening 121 at a front surface of the PDP electrode 111, is provided with a protective film 112. The PDP electrode 111 extends from an outer periphery of the protective film 112 by a predetermined dimension toward an outer periphery of the PDP 110, thereby providing an electrode face 113 (first opposing face). The PDP 110 is controlled by the processor (not shown) connected to the PDP electrode 111 to display an image.

The chassis 130 is made from a conductive material. Although not shown, the chassis 130 may be substantially shaped like, for instance, a box with its top side being opened. The chassis 130 is disposed within the front case 120 and grounded. The chassis 130 is provided with a grounding electrode face 131 (second opposing face) that faces the electrode face 113 of the PDP 110. The chassis 130 also includes a PDP mounting portion (not shown) for mounting the PDP 110, a board mounting portion (not shown) for mounting the circuit board on which the processor is provided, and the like. The PDP 110, the circuit board and the like are fixed thereon by the mounting portions.

The gasket 200, which has a substantially L-shaped cross section, longitudinally extends along the opening 121 of the front case 120. The gasket 200 is disposed to extend around the entire circumference of the opening 121 of the front case 120. As shown in Fig. 2, the gasket 200 includes a body 210, a projection 220 raised from a first end of the body 210, and a conductive fiber member 230. In addition, the gasket 200 is mounted such that the body 210 is sandwiched between the electrode face 113 of the PDP 110 and the grounding electrode face 131 of the chassis 130 while a projecting end 221 of the projection 220 is sandwiched between an inner surface 124 of the front case 120 and the PDP 110.

The body 210 is exemplarily formed from an elastic and non-conductive synthetic resin in a sponge-like manner and shaped substantially like a plate. The body 210 includes: a PDP-side face 211 facing the PDP 110; a chassis-side face 212 facing the chassis 130; and a connecting face 213 provided opposite to the first end of the body 210 (i.e., the end at which the projection 220 is provided) and contiguous to the PDP-side face 211 and the chassis-side face 212. The PDP-side face 211 includes a bulging portion 211A that: covers a portion that extends from a second end of the body 210 at which the PDP-side face 211 is contiguous to the connecting face 213 to the first end of the body 210 where the projection 220 is provided; in its entirety defines an arc shape in cross sectional view; and centrally bulges toward the PDP 110 in an arc shape. When the gasket 200 is mounted, the bulging portion 211A is pressed by the electrode face 113 of the PDP 110 and elastically deformed. When the bulging portion 211A is pressed to be elastically deformed, the body 210, which is formed from an elastic sponge member as described above, generates a reaction force to bias the PDP-side face 211 and the chassis-side face 212 respectively to the electrode face 113 and the grounding electrode face 131. With this arrangement, the PDP-side face 211 and the chassis-side face 212 of the body 210 are pressed to be in closer contact respectively with the electrode face 113 and the grounding electrode face 131. The shape of the bulging portion 211A is not limited to such an arc shape as described above but the bulging portion 211A may bulge to define any other free-form surface. For instance, the bulging portion 211 A may have such a shape that the portion extending from the second end of the body 210 (where the PDP-side face 211 is contiguous to the connecting face 213) to the first end of the body 210 (where the projection 220 is provided) partially protrudes toward the PDP 110.

The projection 220 is provided on the first end of the body 210, which is located opposite to the second end at which the connecting face 213 extends along a longitudinal direction of the gasket 200. The projection 220 is made from the same material as the body 210, i.e., an elastic sponge member, and integrated with the body 210. The projecting end 221 of the projection 220 includes a case abutting surface 221A that is substantially flat and faces the inner surface 124 of the front case 120. When the gasket 200 is mounted, the case abutting surface 221A of the projecting end 221 abuts on the inner surface 124 of the front case 120. With this arrangement, for instance, even when the front case 120 is pressed toward the PDP 110 at the time when the front case 120 is mounted, a biasing force generated by the elastic projection 220 can press back the front case 120, thereby preventing a contact of the flange 122 of the opening 121 with the surface of the PDP 110. The case abutting surface 221A of the projecting end 221 may not be of such a substantially flat shape as described above but may be of any other shape such as arc shape or wave shape.

The projection 220 includes a decorative surface 222 at a lateral surface that is opposite to a side where the chassis-side face 212 of the case abutting surface 221A is provided. The decorative surface 222, which is a portion that is visually recognizable through the clearance provided between the PDP 110 and the flange 122 with the gasket 200 being sandwiched between the front case 120 and the PDP 110, is exemplarily colored in the same color as the front case 120. The decorative surface 222 may not be colored in the same color as the front case 120 but may be colored in another color. Alternatively, by adding a colorant to the sponge member for forming the gasket 200 when the sponge member is manufactured, the decorative surface 222 may be colored in such a color that is in harmony with the color of the front case 120.

The conductive fiber member 230 includes a belt-like conductive flexible member(s) 231 formed in a belt-like shape from conductive and flexible fiber. The belt-like conductive flexible member 231 covers the PDP-side face 211 of the body 210, the connecting face 213 of the body 210 and the chassis-side face 212 of the body 210. A portion of the conductive fiber member 230 that covers the PDP-side face 211 and the chassis-side face 212 of the body 210 is equivalent to a conductive flexible portion of the present invention while a portion of the conductive fiber member 230 that covers the connecting face 213 is equivalent to a connecting portion of the present invention. The conductive fiber member 230 is attached to the body 210 by, for instance, an adhesive. Longitudinally along the gasket 200, a bonding portion 232 is provided to the portion of the conductive fiber member 230 attached to the chassis-side face 212. The bonding portion 232 is attached to the grounding electrode face 131 of the chassis 130, and fixes the gasket 200 onto the chassis 130.

### Mounting Operation(s) of Gasket

Next, mounting operation(s) of the gasket 200 will be described.

Initially, the gasket 200 is fixed on the grounding electrode face 131 of the chassis 130. In other words, the bonding portion 232 attached on the chassis-side face 212 of the body 210 of the gasket 200 is bonded to the grounding electrode face 131 of the chassis 130. At this time, as shown in Fig. 1, the gasket 200 is mounted thereto such that a lateral surface of the projection 220 of the gasket 200 adjacent to the body 210 abuts on an end periphery 132 of the chassis 130 while the projection 220 projects from the end periphery 132 toward the front case 120.

Then, as shown in Fig. 1, the PDP 110 is mounted on the PDP-mounting portion so that the electrode face 113 of the PDP electrode 111 faces the grounding electrode face 131 of the chassis 130. At this time, while pressing the gasket 200 to the chassis 130 by the electrode face 113 of the PDP 110 so as to deformably press the bulging portion 211A provided on the PDP-side face 211 of the body 210 of the gasket 200, the PDP 110 is mounted thereto. With this arrangement, the bulging portion 211A of the gasket 200 is bent toward the chassis-side face 212, and an elastic force of the body 210 biases the PDP-side face 211 to the electrode face 113 and the chassis-side face 212 to the grounding electrode face respectively. Accordingly, the conductive fiber member 230 attached on the PDP-side face 211 and the chassis-side face 212 is favorably brought into close contact with the electrode face 113 and the grounding electrode face 131.

Subsequently, the chassis 130 is mounted on the front case 120. At this time, in order to provide the predetermined clearance 123 between the PDP 110 and the end of the flange 122 of the front case 120, the projecting end 221 of the projection 220 of the gasket 200 is brought into contact with the inner surface 124 of the front case 120. With this arrangement, even when the front case 120 is curved toward the PDP 110 due to an impact caused by a mounting of the front case 120, the projection 220 presses back the inner surface 124 of the front case 120, thereby preventing a contact of the end of the flange 122 with the PDP 110.

### Effect(s) and Advantage(s) of PDP Display Unit

As described above, according to the arrangement of the PDP display unit 100 of the present embodiment, the gasket 200 includes: the body 210 that includes the PDP-side face 211 facing the electrode face 113 of the PDP 110 and the chassis-side face 212 facing the grounding electrode face 131 of the chassis 130; and the projection 220 raised from the first end of the body 210 upward to the inner surface 124 of the front case 120. The body 210 further includes the conductive fiber member 230 continuously formed to cover the PDP-side face 211, the connecting face 213 and the chassis-side face 212.

With this arrangement, by bringing the PDP-side face 211 into contact with the electrode face 113 of the PDP 110 and also bringing the chassis-side face 212 into contact with the grounding electrode face 131 of the chassis 130, the PDP electrode 111 and the grounding electrode face 131 of the chassis 130 can be electrically connected with each other via the conductive fiber member 230. Accordingly, the PDP 110 can be grounded, whereby electromagnetic waves generated in the PDP 110 can be favorably eliminated.

The body 210 and the projection 220 of the gasket 200 are integrally formed, and the projection 220 is disposed between the front case 120 and the PDP 110. With this arrangement, the projecting end 221 of the projection 220 abuts on the inner surface 124 of the front case 120, thereby restricting the position of the front case 120. Specifically, even when the front case 120 approaches the PDP 110, the projecting end 221 of the projection 220 abuts on the inner surface 124 of the front case 120 to outwardly bias the front case 120, thereby preventing a contact of the projecting end of the flange 122 with the surface of the PDP 110. Thus, damages of the PDP 110 and abnormal noises caused by a contact of the front case 120 with the PDP 110 can be prevented.

Further, a buffer member for restricting the movement of the front case 120 such as cushion rubber does not need to be additionally provided, thereby contributing to a decrease in the number of components. Alternatively, since such a cushion rubber is not required, the flange 122 of the front case 120 can be provided closer to the chassis 130, so that a wider opening area can be spared for the opening 121. Accordingly, not only the display area of the PDP 110 can be enlarged but also a size of the front case 120 can be reduced, which contributes to a better design of the PDP display unit 100.

The decorative surface 222 is provided on the lateral surface of the projection 220 of the gasket 200. With this arrangement, by decorating the decorative surface 222, for instance, substantially in the same color as the color of the front case 120, the portion visually recognizable through the clearance 123 provided between the flange 122 of the front case 120 and the PDP 110 can present a favorable external appearance.

The PDP-side face 211 of the body 210 of the gasket 200 is provided with the bulging portion 211 A bulging toward the PDP 110. Thus, the PDP-side face 211 is thickened at the bulging portion 211A. With this arrangement, by pressing the PDP 110 to the bulging portion 211 A so as to press the bulge of the bulging portion 211 A when the gasket 200 is mounted, the body 210 can be easily deformed. Accordingly, the gasket 200 can be easily elastically deformed without applying an excessive force thereto when the gasket 200 is mounted, thereby preventing damages of the PDP 110. In addition, the PDP display unit 100 can be more favorably assembled.

Since the body 210 is formed from an elastic sponge member, a biasing force for outwardly pressing back the PDP-side face 211 and the chassis-side face 212 is generated when the bulging portion 211A is pressed. With this arrangement, closer contact of the PDP-side face 211 with the electrode face 113 of the PDP 110 and closer contact of the chassis-side face 212 with the grounding electrode face 131 of the chassis 130 can be established, whereby the PDP 110 and the chassis 130 can be favorably electrically connected. Accordingly, the PDP 110 can be grounded with enhanced accuracy, whereby electromagnetic waves generated in the PDP 110 can be favorably eliminated.

Since the body 210 and the projection 220 are integrally formed in the gasket 200, manufacturing of the gasket 200 can be facilitated and manufacturing cost thereof can be reduced.

The conductive fiber member 230 is integrally provided by the belt-like conductive flexible member(s) 231 that covers the PDP-side face 211, the connecting face 213 and the chassis-side face 212. With this arrangement, by merely covering the PDP-side face 211, the connecting face 213 and the chassis-side face 212 of the body 210 with the belt-like conductive flexible member(s) 231, the conductive flexible portion and the connecting portion can be easily provided, thereby contributing to favorable manufacturability.

According to the above arrangement, since the surface of the PDP 110 is exposed through the opening, there is no need to separately provide a component such as a screen filter. Thus, the thickness of the PDP display unit 100 can be reduced.

The gasket 200 is disposed along the opening 121 of the front case 120 so as to extend around the entire circumference of the opening 121. Accordingly, the entire circumference of the PDP 110 can be grounded, whereby electromagnetic waves generated in the PDP 110 can be favorably eliminated.

### Modification(s) of Embodiment(s)

It should be noted that the present invention is not limited to the above-described exemplary embodiment but may include the following modification as far as an object of the invention can be achieved.

Specifically, while the body 210 and the projection 220 are integrally formed from the same material in the above exemplary arrangement of the gasket 200, the gasket 200 may be of an arrangement in which a separately-provided body and a separately-provided projection are integrated. In the above arrangement, by setting an elastic force of the projection 220 to be larger than that of the body 210, contact of the front case 120 with the PDP 110 can be more reliably prevented.

While the conductive fiber member 230 is exemplarily provided by the belt-like conductive flexible member(s) 231 that covers the PDP-side face 211, the connecting face 213 and the chassis-side face 212 of the body 210, the arrangement is not limited thereto. For instance, in an arrangement in which the belt-like conductive flexible members 231 are provided respectively on the PDP-side face 211 and the chassis-side face 212, a conductive component such as metal wire may connect the belt-like conductive flexible members 231 with each other. While the body 210 is exemplarily formed from a non-conductive sponge member, the body 210 may be formed from a conductive sponge member. According to such an arrangement, since the conductive flexible portion and the connecting portion of the present invention are formed from the sponge member, there is no need to provide the conductive fiber member 230, which contributes to further simplification in the arrangement of the gasket 200.

While the decorative surface 222 of the gasket 200 is exemplarily colored in substantially the same color as the front case 120, the arrangement is not limited thereto. For instance, the decorative surface 222 may be colored in any suitable color, depending on designs of the PDP display unit 100. Alternatively, as described above, the sponge member for forming the body 210 and the projection 220 of the gasket 200 may be colored.

While the conductive fiber member 230 exemplarily covers the PDP-side face 211, the connecting face 213 and the chassis-side face 212 of the body 210 in the above exemplary embodiment, the conductive fiber member 230 may cover portions of the gasket 200 other than the projecting end 221 of the projection 220. In such an arrangement, by coloring the conductive fiber member 230 attached on the decorative surface 222 of the projection 220 in a color corresponding to the color of the front case 120, or by coloring the conductive fiber member 230 in a color corresponding to the color of the front case 120, the decorative surface 222 visually recognizable through the clearance 123 can present favorable external appearance.

Although an arrangement in which the conductive fiber member 230 also covers the projecting end 221 of the projection 220 may be a possible arrangement, the front case 120 may be damaged or shavings may be generated when the front case 120 contacts the projecting end 221. In such an arrangement, in order to prevent damages of the front case 120 and generation of shavings, a filter for reducing friction between the projecting end 221 and the front case 120 may be provided on the case abutting surface 221 A of the projecting end 221.

While the bulging portion 211 A is exemplarily provided on the body 210 of the gasket 200, the bulging portion 211 A may not be provided. In other words, the gasket 200 may be shaped such that the PDP-side face 211 is substantially parallel to the chassis-side face 212. In such an arrangement, damages possibly caused when the PDP 110 is mounted on the chassis 130 can be prevented by, for example, using a softer member as the sponge member or by increasing a thickness dimension of the body 210. Alternatively, both of the PDP-side face 211 and the chassis-side face 212 of the gasket 200 may be provided with bulging portions.

While the bonding portion 232 is exemplarily provided on the conductive fiber member 230 attached on the chassis-side face 212 of the gasket 200 and the gasket 200 is exemplarily attached and fixed to the chassis 130, a bonding portion may be provided, for instance, on the PDP-side face 211, and the gasket 200 may be attached to the electrode face 113 of the PDP 110.

While the gasket 200 is exemplarily arranged to extend around the entire circumference of the opening 121, the arrangement is not limited thereto. The gasket 200 may be arranged to extend along a part of the opening 121. For instance, four corners of the opening may be each provided with the gasket 200, or gaskets 200 may be disposed with a predetermined space being interposed between each other.

An electronic device on which the gasket 200 is mounted is not limited to the PDP display unit 100 but may be an in-vehicle or set-up recorder, reproducer or recording-and-reproducing device for recording and reproducing music and image. Further examples of the electronic device include a personal computer, a mobile phone, a television device and a navigation device.

### Effect(s) and Advantage(s) of Embodiment(s)

As described above, according to the arrangement of the PDP display unit 100 of the present embodiment, the gasket 200 includes: the body 210 that includes the PDP-side face 211 facing the electrode face 113 of the PDP 110 and the chassis-side face 212 facing the grounding electrode face 131 of the chassis 130; and the projection 220 raised from the first end of the body 210 upward to the inner surface 124 of the front case 120. The body 210 further includes the conductive fiber member 230 continuously formed to cover the PDP-side face 211, the connecting face 213 and the chassis-side face 212.

With this arrangement, the PDP electrode 111 and the grounding electrode face 131 of the chassis 130 can be electrically connected with each other, whereby electromagnetic waves generated in the PDP 110 can be favorably eliminated. In addition, by bringing the projecting end 221 of the projection 220 in contact with the inner surface 124 of the front case 120, the front case 120 can be outwardly biased even when the front case 120 approaches the PDP 110, thereby preventing damages of the PDP 110 and abnormal noises caused by a contact of the front case 120 with the PDP 110. Further, since a buffer member such as cushion rubber for restricting the movement of the front case 120 does not need to be separately provided, the number of components can be reduced, and an arrangement of the PDP display unit 100 can be simplified. Moreover, a size of the front case 120 can be reduced, and the display area of the PDP can be enlarged with an increase in the opening area of the opening 121. **Industrial Applicability**

The present invention, which relates to an electric conductor for conducting electricity and an electronic device, is particularly applicable as an electric conductor for grounding electromagnetic waves of a PDP.

## Claims

1. An electric conductor for electrically connecting an electronic-component connecting member with a conductive member, the electronic-component connecting member being electrically connected to an electronic component disposed within a case, the electronic-component connecting member having a first opposing face that faces one surface of the case, the conductive member being provided between the case and the electronic-component connecting member, the conductive member having a second opposing face that faces the first opposing face of the electronic-component connecting member, the electric conductor comprising:
a substantially plate-shaped body formed from an elastic material, the body having paired faces that substantially face the first opposing face of the electronic-component connecting member and the second opposing face of the conductive member respectively;
a projection formed from an elastic material integrally with the body, the projection projecting from a first end of the body toward the one surface of the case, a projecting end of the projection adapted to abut on the one surface of the case;
conductive flexible portions made from a conductive and flexible material, the conductive flexible portions being respectively provided on the paired faces of the body; and
a connecting portion that electrically connects the conductive flexible portions provided on the paired faces with each other.

2. The electric conductor according to Claim 1, wherein a first face of the paired faces of the body partially protrudes toward the first opposing face, the first face of the paired faces facing the first opposing face of the electronic-component connecting member.

3. The electric conductor according to Claim 1 or 2, wherein the paired conductive flexible portions and the connecting portion are integrally formed.

4. An electronic device, comprising:
a case;
an electronic component disposed within the case;
an electronic-component connecting member electrically connected to the electronic component, the electronic-component connecting member having a first opposing face that faces one surface of the case;
a conductive member provided between the case and the electronic-component connecting member, the conductive member having a second opposing face that faces the first opposing face; and
the electric conductor according to any one of Claims 1 to 3, the electric conductor electrically connecting the conductive member with the electronic-component connecting member.

5. The electronic device according to Claim 4, wherein
the electronic component is a display that displays a predetermined image in accordance with an image signal,
the case has an opening through which the display is externally visually recognizable, and
the electric conductor is disposed such that the conductive flexible portions electrically connect the electronic-component connecting member having been connected to the display with the conductive member while the projecting end of the projection abuts near the opening of the case.

6. The electronic device according to Claim 5, wherein
the electric conductor is disposed along the opening such that the projection is located adjacent to the opening while the body is located apart from the opening, and
a lateral surface of the electric conductor is decorated in a manner corresponding to the electronic device, the lateral surface being visually recognizable through the opening.

7. The electronic device according to Claim 6, wherein the electric conductor is disposed to extend around an entire circumference of the opening.
